# DEMANDE DE BREVET EUROPEEN

(11) **EP 4 766 034 A1**
(43) Date de publication de la demande: **24.06.2026**
(21) Numéro de dépôt: 25223035.4
(22) Date de dépôt: 12.12.2025
(51) Int. Cl.: H05K 1/02, H05K 1/18, H01R 12/55, H01R 4/30

(54) **SYSTÈME D'ÉLECTRONIQUE DE PUISSANCE**

(30) Priorité: 18.12.2024 FR 2414564
(71) Demandeur: Valeo eAutomotive Germany GmbH, 91056 Erlangen (DE)
(72) Inventeur: CHINNATHAMBI, Gowardanan, 94460 Valenton (FR); GONCALVES-DA-COSTA, Ricardo, 94000 Créteil (FR); GILLION, Jean-Noel, 94460 Valenton (FR)
(74) Mandataire: Valeo Powertrain Systems

(57) **Abrégé**

La présente invention concerne un système d'électronique de puissance (2) comprenant au moins un dispositif électronique, une carte de circuits imprimés (4) sur laquelle sont installés une pluralité de composants électriques, et des branches de polarité (6) positives et négatives configurées pour lier électriquement le dispositif électronique à un moyen de stockage en énergie électrique, chaque branche de polarité (6) étant formée respectivement par une première branche de polarité (8, 12) et une deuxième branche de polarité (10, 14) distinctes l'une de l'autre et connectées électriquement l'une à l'autre, la première branche de polarité positive (8) et la première branche de polarité négative (12) étant respectivement connectées électriquement à la deuxième branche de polarité positive (10) et à la deuxième branche de polarité négative (14) par l'intermédiaire de la carte de circuits imprimés (4).

## Description

La présente invention concerne le domaine de l'électronique et de l'électrotechnique, et plus particulièrement le domaine des dispositifs d'électronique de puissance.

Les dispositifs d'électronique de puissance sont des dispositifs électriques intégrés dans de nombreux équipements et notamment dans des véhicules automobiles tels que des véhicules électriques ou hybrides. Ces dispositifs d'électronique de puissance comprennent classiquement un boitier délimitant un espace interne au sein duquel est logé au moins un composant électrique, et une carte de circuits imprimés sur laquelle sont installés d'autres composants tels que des circuits intégrés, des condensateurs ou encore des inductances.

Ces dispositifs d'électronique de puissance peuvent notamment être des convertisseurs de tension destinés à opérer une conversion entre un courant électrique continu et un courant électrique alternatif. Au sein des véhicules électriques ou hybrides, ces convertisseurs de tensions sont classiquement interposés entre un moyen de stockage en énergie électrique et une machine électrique destinée à générer un couple d'entrainement du véhicule pour permettre la mise en mouvement dudit véhicule.

À cet effet, le dispositif d'électronique de puissance est connecté électriquement par un premier ensemble de connexion électrique au moyen de stockage en énergie électrique et par un deuxième ensemble de connexion électrique à la machine électrique et il comporte une pluralité de composants électroniques disposés de part et d'autre d'une carte de circuits imprimés et aptes à générer une conversion du courant électrique entre les deux ensembles de connexion.

Parmi ces composants électriques, on peut par exemple noter la présence d'un condensateur destiné à lisser les pics de tension lors du fonctionnement du dispositif d'électronique de puissance, ce condensateur ayant à être raccordé au dispositif de stockage électrique et à la carte de circuits imprimés. Le positionnement du condensateur peut impliquer d'avoir à le raccorder au moyen de stockage en énergie électrique via un ensemble de connexion électrique qui traverse la carte de circuits imprimés. Ceci implique de prévoir un orifice dans cette carte de circuits imprimés suffisamment grand pour laisser passer les bus de connexion formant ces ensembles de connexion électriques. Dans ce contexte, il convient également de faire passer du courant dans la carte de circuits imprimés, pour d'une part alimenter les composants électroniques et d'autre part récupérer des informations relatives au courant électrique circulant entre le moyen de stockage en énergie électrique et le dispositif d'électronique de puissance, par exemple pour piloter le fonctionnement des composants électroniques et leur donner des instructions de commande appropriées. Pour récupérer ces informations, il est connu de mettre en œuvre des broches de signal s'étendant depuis des bus de connexion du premier ensemble de connexion électrique jusqu'à la carte de circuits imprimés, les broches de signal étant connectées à la carte de circuits imprimés via leur extrémité libre à l'opposé du premier ensemble de connexion électrique. Notamment, il est connu de faire passer l'extrémité des broches de signal à travers la carte de circuits imprimés pour faire coopérer cette extrémité avec un dispositif de fixation embarqué sur la carte de circuits imprimés.

Bien que fonctionnelle, cette solution n'est pas optimale car on comprend que le positionnement des extrémités des broches de signal dans le dispositif de fixation doit être précis et que le fait que ces broches soient portées par les bus de connexion du premier ensemble de connexion électrique fait intervenir un grand nombre de tolérances de fabrication et d'assemblage. Par ailleurs, les broches de signal sont classiquement réalisées sous forme de lamelles fines, susceptibles de fléchissement, et leur positionnement en porte à faux des bus de connexion est propice à un tel fléchissement. Il peut résulter de ce constat un montage en force des extrémités des broches de signal dans les dispositifs de fixation qui génère une formation de particules de matière des broches, par friction contre les moyens de fixation. Par ailleurs, cette disposition implique de devoir positionner les broches de signal à proximité des bus de connexion du premier ensemble de connexion électrique.

La présente invention s'inscrit dans ce contexte et se propose de pallier au moins certains des inconvénients de l'art antérieur. La présente invention se propose notamment de fournir un système d'électronique de puissance dans lequel le courant peut être transmis efficacement au sein d'un ensemble de connexion électrique amené à traverser une carte de circuits imprimés et dans lequel une partie du courant électrique circulant entre un moyen de stockage en énergie électrique et un dispositif électronique via cet ensemble de connexion électrique peut être collectée au niveau de la carte de circuits imprimés sans contraintes élevées de positionnement de la carte de circuits imprimés par rapport au dispositif électronique.

Ainsi, la présente invention porte sur un système d'électronique de puissance comprenant au moins un dispositif électronique, une carte de circuits imprimés sur laquelle sont installés une pluralité de composants électriques, et des ensembles de connexion de polarité positive et négative configurés pour lier électriquement le dispositif électronique à un moyen de stockage en énergie électrique, chaque ensemble de connexion d'une polarité donnée étant formé respectivement par une première branche de polarité et une deuxième branche de polarités distinctes l'une de l'autre et connectées électriquement l'une à l'autre, la première branche de polarité positive et la première branche de polarité négative étant respectivement connectées électriquement à la deuxième branche de polarité positive et à la deuxième branche de polarité négative par l'intermédiaire de la carte de circuits imprimés.

Le système d'électronique de puissance peut former un convertisseur de tension configuré pour opérer notamment une conversion entre un courant électrique continu et un courant électrique alternatif. À cet effet, le système d'électronique de puissance est disposé entre un moyen de stockage en énergie électrique et une machine électrique. À titre d'exemple, le dispositif électronique forme un condensateur permettant de lisser les pics de tension lors de la conversion.

Ces ensembles de connexion de polarité positive et négative assurent ici la liaison électrique entre le moyen de stockage en énergie électrique et le système d'électronique de puissance, via le dispositif électrique.

Chaque ensemble de connexion de polarité positive et négative est respectivement formé d'une première branche et d'une deuxième branche qui sont connectées l'une à l'autre pour former ledit ensemble de connexion au sein duquel est apte à circuler courant un électrique à haute tension, c'est-à-dire de l'ordre d'au moins 800. Cette réalisation de l'ensemble de connexion en deux branches facilite l'assemblage du système électronique de puissance, notamment en permettant de fixer dans un premier temps une des deux branches d'un ensemble de connexion au dispositif électronique et l'autre des deux branches au moyen de stockage électrique puis de les relier l'un à l'autre dans un deuxième temps.

Selon l'invention, les deux branches d'un même ensemble de connexion, c'est-à-dire les deux branches de polarité positive ensembles et/ou les deux branches de polarité négative ensembles, sont directement solidarisées à la carte de circuits imprimés de sorte qu'un courant électrique est apte à passer de l'une des branches d'une polarité donnée à l'autre branche de ladite polarité donnée par l'intermédiaire de la carte de circuits imprimés. En d'autres termes, un courant électrique circulant dans un ensemble de connexion d'une polarité donnée, circule entre la première branche de cette polarité et la deuxième branche de cette polarité en passant par la carte de circuits imprimés.

Cette solidarisation des branches de polarité directement sur la carte de circuits imprimés permet de faciliter l'assemblage du système d'électronique de puissance en limitant le nombre de composants nécessaires pour assurer une liaison électrique entre le moyen de stockage en énergie électrique, le dispositif électronique et la carte de circuits imprimés.

Cette configuration est notamment avantageuse dans un contexte où pour un ensemble de connexion donné, de polarité positive ou négative, une branche est reliée au dispositif électrique positionné d'un côté de la carte de circuits imprimés et l'autre branche est reliée au moyen de stockage électrique qui est agencé de l'autre côté de la carte de circuits imprimés, et donc dans un contexte où l'ensemble de connexion doit passer d'un côté à l'autre de la carte de circuits imprimés. La configuration de l'invention permet de faire passer le courant au sein de cet ensemble de connexion sans qu'il soit nécessaire de percer la carte de circuits imprimés de larges orifices susceptibles de faire passer l'une des branches à travers la carte de circuits imprimés.

Selon une caractéristique de l'invention, la première branche de polarité positive est solidarisée à la deuxième branche de polarité positive par un premier élément de fixation, la première branche de polarité négative étant solidarisée à la deuxième branche de polarité négative par un deuxième élément de fixation, le premier élément de fixation et le deuxième élément de fixation s'étendant à travers la carte de circuits imprimés.

Pour un ensemble de connexion donné, la première branche est plaquée contre une face de la carte de circuits imprimés et la deuxième branche est plaquée contre la face opposée de cette carte de circuits imprimés et l'élément de fixation correspondant traverse la carte de circuits imprimés pour les lier l'une à l'autre, en les immobilisant contre la carte de circuits imprimés. Ces éléments de fixation permettent de s'assurer que les branches de polarité sont convenablement solidarisées à la carte de circuits imprimés et convenablement positionnées par rapport à ladite carte de circuits imprimés. De plus, ces éléments de fixation peuvent être formés d'un matériau métallique participant à permettre la circulation d'un courant électrique entre les branches d'une polarité donnée.

Selon une caractéristique de l'invention, les branches de polarité positive comprennent chacune un premier orifice et les branches de polarité négative comprennent chacune un deuxième orifice, la carte de circuits imprimés comprenant une première ouverture disposée en regard des premiers orifices et une deuxième ouverture disposée en regard des deuxièmes orifices, le diamètre des ouvertures étant inférieur aux diamètres des orifices associés.

La différence de diamètres entre l'ouverture et les orifices correspondants permet d'assurer un assemblage facile à réaliser sans avoir la nécessité que les centres de l'ouverture et des orifices soient parfaitement alignés. Par ailleurs, il convient, pour positionner avec précision l'élément de fixation et le maintenir dans sa position de fixation, d'avoir un des trous qui soit de dimension ajustée par rapport à celle de l'élément de fixation, par exemple une tige de vis de fixation, et il est avantageux que ce soit l'ouverture formée dans la carte de circuits imprimés qui présente cette dimension ajustée, pour limiter la place perdue sur la carte de circuits imprimés par cet assemblage. Par ailleurs, cela permet de s'assurer qu'une piste électrique de la carte de circuits imprimés, entourant au plus près l'ouverture, soit au contact des branches plaquées de part et d'autre de la carte de circuits imprimés.

Selon une caractéristique de l'invention, chaque élément de fixation comporte un écrou noyé dans la matière de l'une des branches de polarité et une vis de serrage complémentaire de l'écrou et apte à traverser successivement l'une des branches d'une polarité donnée, la carte de circuits imprimés et l'autre des branches de ladite polarité donnée.

Une telle architecture de l'élément de fixation facilite l'assemblage en limitant le nombre de pièces impliquées dans la mise en œuvre du rapprochement des branches d'un ensemble de connexion d'une polarité donnée l'une vers l'autre.

Selon une caractéristique de l'invention, chaque élément de fixation est configuré pour rapprocher l'une vers l'autre la première branche d'un ensemble de connexion et la deuxième branche de cet ensemble de connexion de sorte que la carte de circuits imprimés est comprimée entre cette première branche et cette deuxième branche de polarité.

Ainsi, on s'assure que chacune des branches de polarité formant un ensemble de connexion électrique sont bien au contact de la carte de circuits imprimés. De plus, un tel rapprochement permet de rendre l'ensemble formé des branches de polarité et de la carte de circuits imprimés plus rigide, ce qui limite le risque de détérioration du fait de mouvements parasites.

Selon une caractéristique de l'invention, une extrémité des premières branches de polarité et des deuxièmes branches de polarité est en appui plan contre la carte de circuits imprimés. Cet appui plan permet d'augmenter au maximum la zone de contact des branches de polarité avec la carte de circuits imprimés.

Selon une caractéristique de l'invention, la carte de circuits imprimés comprend une première piste électrique de connexion au contact de la première branche de polarité positive et de la deuxième branche de polarité positive et une deuxième piste électrique de connexion au contact de la première branche de polarité négative et de la deuxième branche de polarité négative, la première piste électrique de connexion et la deuxième piste de connexion électrique étant configurées pour permettre le passage d'un courant électrique à haute tension entre les branches d'un même ensemble de connexion électrique. Au moyen de ces pistes électriques de connexion, il est possible de faire passer le courant électrique haute tension directement à travers l'épaisseur de la carte de circuits imprimés.

Selon une caractéristique de l'invention, la première piste électrique de transmission de signal est électriquement connectée à la première piste électrique de connexion et la deuxième piste électrique de transmission de signal est électriquement connectée à la deuxième piste électrique de connexion.

La connexion électrique de la première piste électrique de transmission de signal à la première piste électrique de connexion permet de connecter électriquement la première piste de transmission de signal à l'ensemble de connexion de polarité positive et la connexion électrique de la deuxième piste électrique de transmission de signal à la deuxième piste électrique de connexion permet de connecter électriquement la deuxième piste de transmission de signal à l'ensemble de connexion de polarité négative. Ainsi, le système d'électronique de puissance est apte à récupérer une information relative au courant électrique circulant dans chaque ensemble de connexion de polarité positive et négative directement par une piste électrique réalisée dans la carte de circuits imprimés.

Selon une caractéristique de l'invention, la première piste électrique de transmission de signal et la deuxième piste électrique de transmission de signal sont configurées pour permettre la circulation d'un courant électrique basse tension.

Ces pistes électriques de transmission de signal permettent à une unité de contrôle de collecter des informations relatives au courant électrique circulant dans les ensembles de connexion sans nécessité de venir lier d'autres broches à la carte de circuits imprimés.

La présente invention porte également sur un véhicule automobile comprenant un système d'électronique de puissance conforme à la présente invention.

D'autres caractéristiques, détails et avantages de l'invention ressortiront plus clairement à la lecture de la description qui suit d'une part, et de plusieurs exemples de réalisation donnés à titre indicatif et non limitatif en référence aux dessins schématiques annexés d'autre part, sur lesquels :

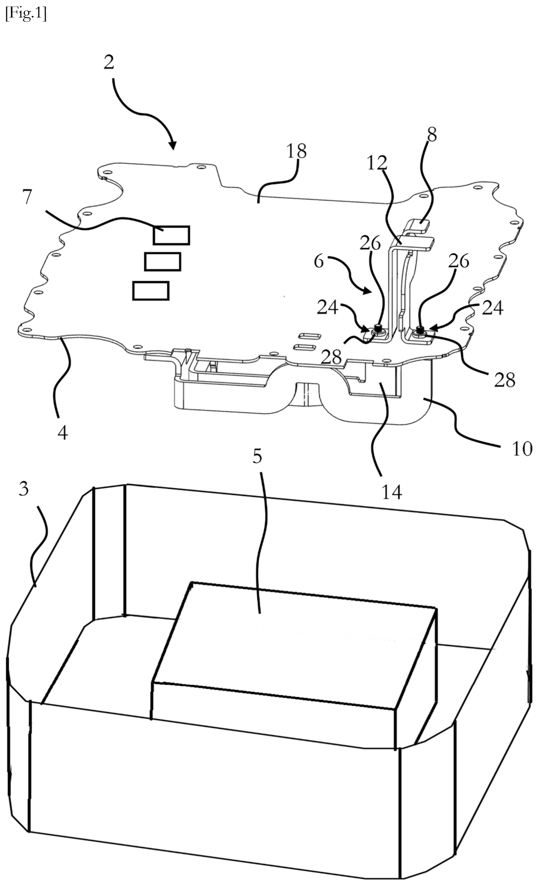

[Fig.1] représente schématiquement une vue d'un système d'électronique de puissance mettant en évidence une première face d'une carte de circuits imprimés sur laquelle sont solidarisées une première branche de polarité positive et une première branche de polarité négative ;

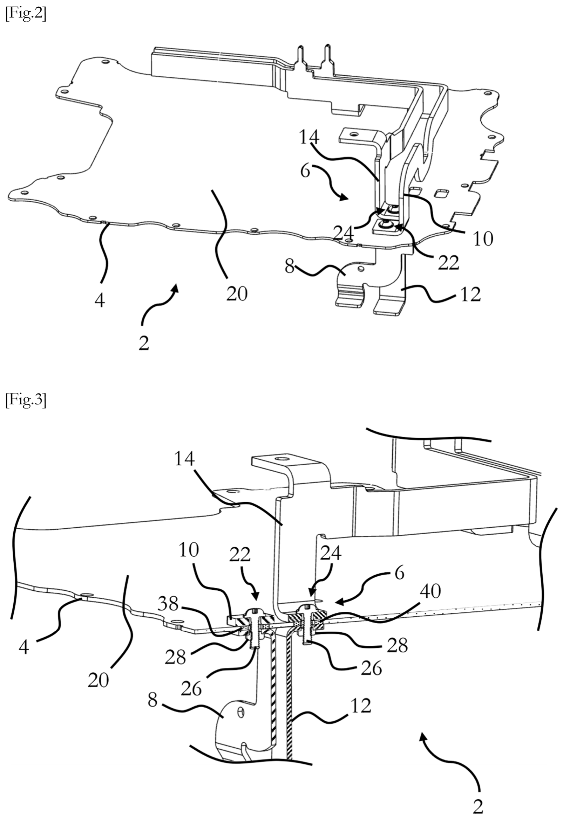

[Fig.2] représente schématiquement une vue du système d'électronique de puissance visible sur la figure 1 mettant en évidence une deuxième face de la carte de circuits imprimés opposée à la première face et sur laquelle sont solidarisées une deuxième branche de polarité positive et une deuxième branche de polarité négative ;
[Fig.3] représente schématiquement une vue de coupe de la carte de circuits imprimés au niveau de la jonction entre les premières branches de polarité et les deuxièmes branches de polarité mettant en évidence la solidarisation desdites branches de polarité au moyen d'un premier élément de fixation et d'un deuxième élément de fixation ;

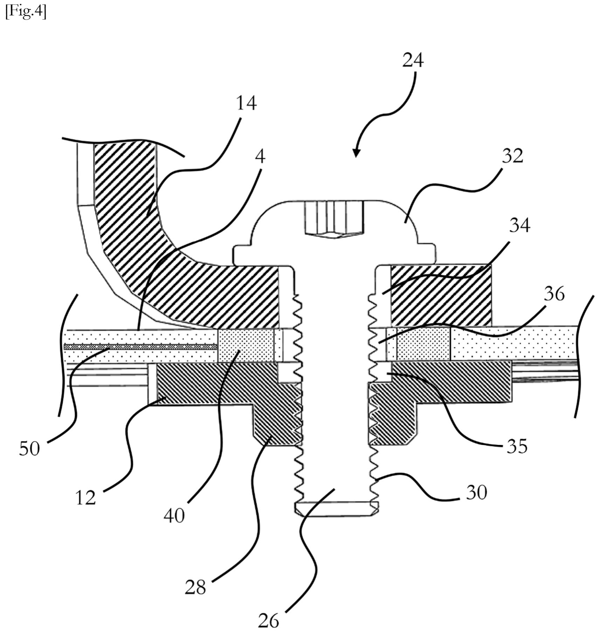

[Fig.4] représente schématiquement une vue de coupe de la carte de circuits imprimés au niveau des branches de polarité négative mettant en évidence la coopération entre une vis de serrage et un écrou de l'élément de fixation noyé dans la matière de la première branche de polarité négative.

Les caractéristiques, les variantes et les différentes formes de réalisation de l'invention peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique et/ou pour différencier l'invention par rapport à l'état de la technique antérieure.

Sur les figures, les éléments communs à plusieurs figures conservent la même référence.

Les figures 1 et 2 illustrent schématiquement un système d'électronique de puissance 2 selon un mode de réalisation de l'invention. Dans le mode de réalisation représenté, le système d'électronique de puissance 2 est destiné à équiper un véhicule électrique ou hybride.

Plus spécifiquement, dans ce mode de réalisation représenté, le système d'électronique de puissance 2 forme un convertisseur de tension interposé, au sein du véhicule électrique ou hybride, entre un moyen de stockage en énergie électrique apte à stocker et à transmettre une énergie électrique et une machine électrique apte à générer un couple d'entrainement pour permettre la mise en mouvement du véhicule électrique ou hybride. Le système d'électronique de puissance 2 est ainsi apte à convertir un courant électrique circulant entre la machine électrique et le moyen de stockage en énergie électrique de sorte que la machine électrique reçoive un courant électrique alternatif et de sorte que le moyen de stockage en énergie électrique reçoive un courant électrique continu.

À cet effet, le système d'électronique de puissance 2 comprend un boitier 3 dans lequel sont logés au moins un dispositif électronique 5, représenté ici schématiquement, et une carte de circuits imprimés 4.

La carte de circuits imprimés 4 comprend une pluralité de composants électriques, et par exemple des transistors 7 représentés schématiquement sur une face de la carte de circuits imprimés, ces composants électriques étant alimentés et reliés les uns aux autres par des pistes électriques formés dans la carte de circuits imprimés. Ces composants électriques sont configurés pour assurer seuls ou en combinaison les uns avec les autres la fonction de conversion de tension, notamment en intégrant le fonctionnement du dispositif électronique 5 logé dans le boîtier et également relié à ladite carte de circuits imprimés. La carte de circuits imprimés 4 est notamment apte à piloter le fonctionnement du système d'électronique de puissance 2 en fonction de requêtes émises par l'utilisateur du véhicule électrique ou hybride.

Le dispositif électronique 5 est ici un condensateur permettant de lisser les pics de tension lors de la conversion et ainsi stabiliser la tension électrique circulant par le système d'électronique de puissance 2. La connexion électrique entre le dispositif électronique 5 et le moyen de stockage en énergie électrique est assurée par des ensembles de connexion électrique 6, respectivement de polarité positive et négative, du système d'électronique de puissance 2. Les ensembles de connexion électrique 6 sont destinées à permettre la circulation d'un courant électrique haute tension, de l'ordre de 800 V, entre le moyen de stockage en énergie électrique et le dispositif électronique.

Chaque ensemble de connexion est formée d'une première branche de polarité et d'une deuxième branche de polarité, distincte de la première branche de polarité, liées électriquement l'une à l'autre. Par la suite, on parlera de branches de polarité positive pour les branches qui sont destinées à former l'ensemble de connexion de polarité positive et on parlera de branches de polarité négative pour les branches qui sont destinées à former l'ensemble de connexion de polarité négative. Ainsi, l'ensemble de connexion de polarité positive est formé d'une première branche de polarité positive 8 et d'une deuxième branche de polarité positive 10. L'ensemble de connexion de polarité négative est formé d'une première branche de polarité négative 12 et d'une deuxième branche de polarité négative 14.

Tel que cela est notamment visible sur la figure 1 qui illustre une première face 18 de la carte de circuits imprimés 4, la première branche de polarité positive 8 et la première branche de polarité négative 12 s'étendent d'un côté de la carte de circuits imprimés, et plus particulièrement du côté de cette première face 18. Ces premières branches sont respectivement plaquées à une extrémité contre la première face 18 de la carte de circuits imprimés et elles présentent respectivement une extrémité libre qui est destinée à être connectée électriquement au moyen de stockage électrique, ici non représenté.

Par ailleurs, et tel que cela est notamment visible sur la figure 2 qui illustre une deuxième face 20 de la carte de circuits imprimés 4 opposée à la première face 18, la deuxième branche de polarité positive 10 et la deuxième branche de polarité négative 14 s'étendent d'un même côté de la carte de circuits imprimés, et plus particulièrement du côté de cette deuxième face 20. Ces deuxièmes branches sont elles aussi respectivement plaquées à une extrémité contre une face de la carte de circuits imprimés, ici la deuxième face 20, et elles présentent une forme complexe permettant leur raccordement électrique au dispositif électronique 5.

Selon l'invention, la première branche de polarité positive 8 est connectée électriquement à la deuxième branche de polarité positive 10, pour former l'ensemble de connexion de polarité positive, par l'intermédiaire de la carte de circuits imprimés 4 et plus particulièrement dans une première zone de connexion dédiée sur la carte de circuits imprimés, et la première branche de polarité négative 12 est connectée électriquement à la deuxième branche de polarité négative 14, pour former l'ensemble de connexion de polarité négative, par l'intermédiaire de cette même carte de circuits imprimés 4, dans une deuxième zone de connexion de la carte de circuits imprimés distincte de la première zone de connexion.

Au regard de ce qui vient d'être décrit, il convient de comprendre, en lien avec la connexion électrique des branches de polarité formant respectivement un ensemble de connexion de polarité donné, qu'un courant électrique circulant depuis le moyen de stockage en énergie électrique jusqu'au dispositif électronique dans l'ensemble de connexion de polarité positive, respectivement négative, circule successivement par la première branche de polarité positive 8, respectivement négative 12, puis par la carte de circuits imprimés 4 et enfin par la deuxième branches de polarité branche de polarité positive 10, respectivement négative 14. Inversement, lorsqu'un courant électrique circule depuis le dispositif électronique jusqu'au moyen de stockage en énergie électrique, le courant électrique circule successivement par les premières branches de polarité 8, 12, la carte de circuits imprimés 4 puis les deuxièmes branches de polarité 10, 14.

Cette connexion électrique est réalisée du fait que d'une part, tel que visible sur la figure 1, les premières branches de polarité 8, 12 sont directement solidarisées à la carte de circuits imprimés 4 et dans une même zone de connexion et le fait que tel que visible sur la figure 2, les deuxièmes branches de polarité 10, 14 sont directement solidarisées à la carte de circuits imprimés 4 et dans une même zone de connexion.

Pour permettre une connexion électrique optimale entre chaque branche formant un ensemble de connexion 6 d'une polarité donnée et la carte de circuits imprimés 4, chaque extrémité d'une branche 8, 10, 12, 14 participant à former un ensemble de connexion 6 qui est destinée à être au contact de la carte de circuits imprimés comprend une partie d'appui qui est sensiblement plane et qui s'étend sensiblement à angle droit par rapport à une partie de base adjacente, de manière à pouvoir former une surface de réception d'une tête de vis d'un moyen de serrage qui va être décrit ci-après et à pouvoir former un appui plan avec la carte de circuits imprimés 4. Cet appui plan entre une branche de polarité positive ou négative et la carte de circuits imprimés 4 permet de s'assurer d'une grande surface de contact, ce qui a pour effet d'une part de s'assurer du contact dans une zone où un courant électrique haute tension peut passer et d'autre part de s'assurer d'une liaison mécanique stable.

La première branche de polarité positive 8 est solidarisée à la deuxième branche de polarité positive 10 par un premier élément de fixation 22 et la première branche de polarité négative 12 est solidarisée à la deuxième branche de polarité négative 14 par un deuxième élément de fixation 24, chacun des éléments de fixation s'étendant à travers la carte de circuits imprimés. Avantageusement, on utilise un même moyen de fixation pour lier ensemble les deux branches d'un même ensemble de connexion et pour s'assurer du contact de ces branches avec la carte de circuits imprimés, ce qui permet de limiter les moyens de fixation à prévoir pour transmettre le courant du moyen de stockage électrique au dispositif électrique 5 et pour transmettre le courant à la carte de circuits imprimés.

Tel que visible sur la figure 3 qui illustre une vue de coupe au niveau de la jonction entre d'une part la première branche de polarité positive 8 et la deuxième branche de polarité positive 10 et d'autre part la première branche de polarité négative 12 et la deuxième branche de polarité négative 14, chaque élément de fixation 22, 24 est formé de la coopération entre une vis de serrage 26 et un écrou 28 noyé dans la matière de la partie plane d'une des branches, ici dans la matière de la partie plane de la première branche correspondante.

La vis de serrage 26 traverse successivement la deuxième branche de polarité positive 10, respectivement négative 14, la carte de circuits imprimés 4 et la première branche de polarité positive 8, respectivement négative 12, et elle coopère alors avec l'écrou 28 de forme complémentaire, c'est-à-dire avec un filetage complémentaire d'un filet 30 de la vis de serrage 26. La vis de serrage 26 comprend une tête de vis 32 qui vient se plaquer contre la partie d'appui formée à une extrémité de deuxième branche, et la coopération de la vis de serrage et de l'écrou 28 a pour effet d'exercer une pression via cette tête de vis contre la deuxième branche de polarité négative 14. On comprend que de la sorte, lors du vissage de la vis de serrage 26, les parties d'appui des deux branches du même ensemble de connexion électrique sont rapprochées l'une de l'autre, la première branche et la deuxième branche d'une même polarité venant comprimer la carte de circuits imprimés 4.

Les branches de polarité positive 8, 10, participant à former l'ensemble de connexion de polarité positive, comprennent chacune un trou et les branches de polarité négative 12, 14, participant à former l'ensemble de connexion de polarité négative, comprennent chacune un orifice 34, tandis que la carte de circuits imprimés 4 comprend une première ouverture disposée dans l'alignement des trous et une deuxième ouverture 36 disposée dans l'alignement des orifices 34. Le diamètre desdites ouvertures est inférieur aux diamètres des orifices et des trous.

Plus spécifiquement, en considérant la figure 4 qui illustre une vue de coupe au niveau du deuxième élément de fixation 24 associé aux deux branches de polarité négative 12, 14, le diamètre des orifices 34 réalisés dans la partie d'appui plane de la première branche de polarité négative 12 et dans la partie d'appui plane de la deuxième branche de polarité négative 14 est sensiblement égal. Le diamètre de la deuxième ouverture 36 est quant à lui inférieur au diamètre des deuxièmes orifices 34 de sorte que le placement de la vis de serrage 26 par rapport aux branches de polarité négative 12, 14 présente une certaine flexibilité facilitant l'assemblage tandis que le diamètre plus faible de la deuxième ouverture 36 permet de mettre en œuvre un positionnement relativement précis des branches de polarité négative 12, 14 par rapport à la carte de circuits imprimés 4.

Il résulte de cette configuration que le courant électrique circulant au sein d'un ensemble de connexion électrique, c'est-à-dire entre la première branche de polarité positive 8, respectivement négative 12 et la deuxième branche de polarité positive 10, respectivement négative 14, circule directement à travers la carte de circuits imprimés 4. À cet effet, la carte de circuits imprimés comprend une première piste électrique de connexion 38, visible sur la figure 3, et une deuxième piste électrique de connexion 40, visible sur les figures 3 et 4. Ces pistes électriques de connexion 38, 40 sont formées de cuivre et sont configurées pour assurer le passage d'un courant électrique de haute tension entre les premières branches de polarité 8, 12 et les deuxièmes branches de polarité 10, 14.

Plus spécifiquement, ces pistes électriques de connexion 38, 40 sont réalisées dans l'épaisseur de la carte de circuits imprimés 4. Cette épaisseur est mesurée le long du plus court segment joignant la première face 18 et la deuxième face 20 de la carte de circuits imprimés 4.

Lorsque le système d'électronique de puissance 2 est assemblé, la première piste électrique de connexion 38 est au contact de la première branche de polarité positive 8 et de la deuxième branche de polarité positive 10 de sorte que l'on forme une continuité électrique entre ces branches et que l'on forme ainsi l'ensemble de connexion électrique de polarité positive. La deuxième piste électrique de connexion 40 est quant à elle au contact de la première branche de polarité négative 12 et de la deuxième branche de polarité négative 14 de sorte que l'on forme une continuité électrique entre ces branches et que l'on forme ainsi l'ensemble de connexion électrique de polarité négative.

Ces pistes de connexion électrique 38, 40 présentent une forme d'œillet venant entourer l'ouverture associée auxdites branches de polarité 6. Il est remarquable, dans un mode de réalisation illustré à la figure 4, que ces pistes de connexion électrique 38, 40 ne s'étendent pas jusqu'au bord de la carte de circuits imprimés délimitant le pourtour de l'ouverture associée, de sorte que ce bord de la carte de circuits imprimés délimitant l'ouverture n'est pas au contact avec la piste de connexion électrique 38, 40 associée.

Les pistes de connexion électrique 38, 40 s'étendent dans l'intégralité de l'épaisseur de la carte de circuits imprimés 4 de sorte à être affleurantes avec la première face 18 et la deuxième face 20 de la carte de circuits imprimés 4. Ainsi, lorsque le système d'électronique de puissance 2 est assemblé, les ensembles de connexion 6, via chacune des deux branches qui les constituent, sont au contact des pistes de connexion électrique 38, 40 correspondantes et un courant électrique peut circuler à travers la carte de circuits imprimés 4 pour passer d'une première branche de polarité 8, 12 à une deuxième branche de polarité 10, 14 associée au sein d'un même ensemble de connexion 6.

Bien entendu, la première piste de connexion électrique 38 et la deuxième piste de connexion électrique 40 ne sont pas au contact l'une de l'autre pour éviter tout dysfonctionnement du système d'électronique de puissance 2. En cela, s'il est souhaitable que les zones de connexion formées dans la carte de circuits imprimés soient proches l'une de l'autre pour faciliter la gestion de l'encombrement des ensembles de connexion dans le système d'électronique de puissance, elles sont suffisamment écartées l'une de l'autre pour que les pistes de connexion électrique puissent être assez étendues sans pour autant se toucher.

En outre, la carte de circuits imprimés 4 comprend une première piste électrique de transmission de signal liée électriquement à l'ensemble de connexion de polarité positive et une deuxième piste électrique de transmission de signal liée électriquement à l'ensemble de connexion de polarité négative. Une telle piste électrique de transmission de signal 50 est illustrée schématiquement sur la figure 4 en relation avec les branches 12, 14 constitutives de l'ensemble de connexion de polarité négative mais une construction similaire pourrait être mise en œuvre pour l'ensemble de connexion de polarité positive.

Ces pistes électriques de transmission de signal 50 permettent à une unité de contrôle de collecter des informations relatives au courant électrique circulant par les branches de polarité. À cet effet, les pistes électriques de transmission de signal 50 circulent sur la carte de circuits imprimés 4 jusqu'à l'unité de contrôle elle-même ou jusqu'à un composant électronique communiquant avec l'unité de contrôle.

À l'instar des pistes électriques de connexion 38, 40, les pistes électriques de transmission de signal 50 sont formées de cuivre. Toutefois, l'épaisseur de ces pistes électriques de transmission de signal 50 est inférieure à l'épaisseur des pistes électriques de connexion 38, 40. En effet, les pistes électriques de connexion 38, 40 sont configurées pour assurer le passage d'un courant électrique de haute tension, tandis que les pistes électriques de transmission de signal sont configurées pour assurer la circulation d'un courant électrique de basse tension. Dans l'exemple illustré, la piste électrique de transmission de signal est sensiblement au centre de l'épaisseur de la carte de circuits imprimés sans que cela soit limitatif de l'invention.

Pour assurer une fabrication simple de la carte de circuits imprimés 4, les pistes électriques de transmission de signal 50 s'étendent directement depuis une piste électrique de connexion 38, 40. Ainsi, la première piste électrique de transmission de signal s'étend depuis la première piste électrique de connexion 38 et la deuxième piste électrique de transmission de signal 50 s'étend depuis la deuxième piste électrique de connexion 40, tel qu'illustré sur la figure 4. On comprend que les pistes électriques de transmission de signal sont liées électriquement aux ensembles de connexion électrique 6 associées par l'intermédiaire de la piste électrique de connexion 38, 40 correspondante.

Une telle construction mettant en œuvre des pistes électriques au sein de la carte de circuits imprimés 4 permet de s'affranchir des contraintes liées à la mise en œuvre de broches venant se connecter à la carte de circuits imprimés 4 en assurant la récupération d'informations relatives au courant électrique circulant dans les branches de polarité 6 au moyen d'un unique assemblage à la carte de circuits imprimés pour chacune des branches de polarité 6.

La présente invention telle qu'elle vient d'être décrite atteint bien le but qu'elle s'était fixé en proposant un système d'électronique de puissance au sein duquel des informations relatives à un courant électrique circulant entre un moyen de stockage en énergie électrique et un dispositif électronique du système d'électronique de puissance sont collectées au moyen d'une piste électrique venant directement se lier électriquement à des branches de polarité solidarisées sur la carte de circuits imprimés.

La présente invention ne saurait toutefois se limiter aux moyens et configurations décrits et illustrés ici et elle s'étend également à tout moyen et toute configuration équivalente ainsi qu'à toute combinaison techniquement opérante de tels moyens.

En variante, la carte de circuits imprimés est une carte de circuit imprimé avec des composants intégrés dans sa structure interne, par exemple soudés en passage dans un four. De telles cartes embarquent plus de Cuivre pour plus de puissance.

Dans un mode de réalisation de cette variante, un insert en cuivre est interposé entre la carte et la deuxième branche de polarité (14). Un insert peut également être interposé entre la première branche de polarité (12) et la carte. La compressibilité de l'insert permet d'éviter de comprimer la carte.

## Revendications

1. Système d'électronique de puissance (2) comprenant au moins un dispositif électronique, une carte de circuits imprimés (4) sur laquelle sont installés une pluralité de composants électriques, et des ensembles de connexion (6) de polarité positive et négative configurés pour lier électriquement le dispositif électronique à un moyen de stockage en énergie électrique, chaque ensemble de connexion (6) d'une polarité donnée étant formé respectivement par une première branche de polarité (8, 12) et une deuxième branche de polarité (10, 14) distinctes l'une de l'autre et connectées électriquement l'une à l'autre, la première branche de polarité positive (8) et la première branche de polarité négative (12) étant respectivement connectées électriquement à la deuxième branche de polarité positive (10) et à la deuxième branche de polarité négative (14) par l'intermédiaire de la carte de circuits imprimés (4).

2. Système d'électronique de puissance (2) selon la revendication 1, dans lequel la première branche de polarité positive (8) est solidarisée à la deuxième branche de polarité positive (10) par un premier élément de fixation (22), la première branche de polarité négative (12) étant solidarisée à la deuxième branche de polarité négative (14) par un deuxième élément de fixation (24), le premier élément de fixation (22) et le deuxième élément de fixation (24) s'étendant à travers la carte de circuits imprimés (4).

3. Système d'électronique de puissance (2) selon la revendication 2, dans lequel les branches de polarité positive (8, 10) comprennent chacune un premier orifice et les branches de polarité négative(12, 14) comprennent chacune un deuxième orifice (34), la carte de circuits imprimés (4) comprenant une première ouverture disposée en regard des premiers orifices et une deuxième ouverture (36) disposée en regard des deuxièmes orifices (34), le diamètre des ouvertures étant inférieur aux diamètres des orifices associés.

4. Système d'électronique de puissance (2) selon la revendication 2 ou 3, dans lequel chaque élément de fixation (22, 24) comporte un écrou (28) noyé dans la matière de l'une des branches de polarité (6) et une vis de serrage (26) complémentaire de l'écrou (28) et apte à traverser successivement l'une des branches d'une polarité donnée, la carte de circuits imprimés (4) et l'autre des branches de ladite polarité donnée.

5. Système d'électronique de puissance (2) selon l'une quelconque des revendications 2 à 4, dans lequel chaque élément de fixation (22, 24) est configuré pour rapprocher l'une vers l'autre la première branche de polarité (8, 12) d'un ensemble de connexion et la deuxième branche de polarité (10, 14) de cet ensemble de connexion de sorte que la carte de circuits imprimés (4) est comprimée entre cette première branche de polarité (8, 12) et cette deuxième branche de polarité (10, 14).

6. Système d'électronique de puissance (2) selon l'une quelconque des revendications 1 à 5, dans lequel une extrémité des premières branches de polarité (8, 12) et des deuxièmes branches de polarité (10, 14) est en appui plan contre la carte de circuits imprimés (4).

7. Système d'électronique de puissance (2) selon l'une quelconque des revendications 1 à 6, dans lequel la carte de circuits imprimés (4) comprend une première piste électrique de connexion (38) au contact de la première branche de polarité positive (8) et de la deuxième branche de polarité positive (10) et une deuxième piste électrique de connexion (40) au contact de la première branche de polarité négative (12) et de la deuxième branche de polarité négative (14), la première piste électrique de connexion (38) et la deuxième piste de connexion électrique (40) étant configurées pour permettre le passage d'un courant électrique à haute tension entre les branches d'un même ensemble de connexion (6).

8. Système d'électronique de puissance (2) selon la revendication 7, dans lequel la première piste électrique de transmission de signal est électriquement connectée à la première piste électrique de connexion (38) et la deuxième piste électrique de transmission de signal est électriquement connectée à la deuxième piste électrique de connexion (40).

9. Système d'électronique de puissance (2) selon l'une quelconque des revendications 7 et 8, dans lequel la première piste électrique de transmission de signal et la deuxième piste électrique de transmission de signal sont configurées pour permettre la circulation d'un courant électrique basse tension.

10. Véhicule automobile comprenant un système d'électronique de puissance (2) selon l'une quelconque des revendications 1 à 9.
